# EUROPÄISCHE PATENTSCHRIFT

(11) **EP 2 729 839 B1**
(45) Veröffentlichungstag und Bekanntmachung des Hinweises auf die Patenterteilung: **20.03.2019**
(21) Anmeldenummer: 12738053.3
(22) Anmeldetag: 05.07.2012
(51) Int. Cl.: G02B 19/00, F21V 7/00, H01L 33/58, F21V 5/00, G02B 27/09

(54) **LICHTBEEINFLUSSUNGSELEMENT ZUR BEEINFLUSSUNG DER LICHTABGABE VON IM WESENTLICHEN PUNKTFÖRMIGEN LICHTQUELLEN SOWIE LEUCHTE MIT LICHTBEEINFLUSSUNGSELEMENT**
LIGHT-INFLUENCING ELEMENT FOR INFLUENCING THE LIGHT EMISSION OF ESSENTIALLY POINT LIGHT SOURCES AND LUMINAIRE HAVING A LIGHT-INFLUENCING ELEMENT
ÉLÉMENT INFLUANT SUR LA LUMIÈRE, SERVANT À INFLUER SUR L'ÉMISSION DE LUMIÈRE DE SOURCES LUMINEUSES SENSIBLEMENT EN FORME DE POINTS ET ÉCLAIRAGE POURVU DUDIT ÉLÉMENT

(30) Priorität: 08.07.2011 DE 102011078865; 27.10.2011 DE 102011085289
(43) Veröffentlichungstag der Anmeldung: 14.05.2014
(73) Patentinhaber: Zumtobel Lighting GmbH, 6850 Dornbirn (AT)
(72) Erfinder: EBNER, Stephan, A-6850 Dornbirn (AT)
(74) Vertreter: Thun, Clemens
(86) Internationale Anmeldenummer: PCT/EP2012/063135
(87) Internationale Veröffentlichungsnummer: WO 2013/007595

(56) Entgegenhaltungen:
- CN-A- 101 324 317
- US-A1- 2007 195 534
- US-A1- 2007 201 225
- US-A1- 2010 038 657
- US-A1- 2010 073 938
- US-A1- 2010 195 330
- US-A1- 2010 284 194
- US-A1- 2011 103 051
- US-B1- 6 554 451

## Beschreibung

Die vorliegende Erfindung betrifft ein Lichtbeeinflussungselement, welches dazu vorgesehen ist, die Lichtabgabe von im Wesentlichen punktförmigen Lichtquellen, insbesondere von LEDs zu beeinflussen. Ferner betrifft die vorliegende Erfindung eine Leuchte mit einem derartigen Lichtbeeinflussungselement.

Die fortschreitende Entwicklung von LEDs in den letzten Jahren führt dazu, dass derartige Lichtquellen zunehmend zu Beleuchtungszwecken eingesetzt werden können. Die mit Hilfe von LEDs erzielbaren Lichtstärken sind mittlerweile ausreichend hoch, so dass LEDs in nahezu sämtlichen Anwendungsgebieten bislang verwendete klassische Lichtquellen wie beispielsweise Glühbirnen, Leuchtstofflampen oder Halogenlampen ersetzen können. Ein Vorteil bei der Verwendung von LEDs besteht dabei darin, dass diese sehr gute Möglichkeiten bieten, die Lichtabgabe zu verändern bzw. zu modifizieren. Moderne Lichtquellen auf LED-Basis bieten beispielsweise insbesondere die Möglichkeit, die Farbe oder Farbtemperatur des abgegebenen Lichts einzustellen.

Grundsätzlich strahlen LEDs Licht in einem verhältnismäßig großen Winkelbereich ab. Es ist deshalb üblich, den LEDs optische Elemente, beispielsweise kleine Reflektoren oder Linsen zuzuordnen, über welche die Lichtabgabe auf einen bestimmten Raumbereich beschränkt bzw. konzentriert wird. Hierdurch kann sichergestellt werden, dass das von der Leuchte insgesamt abgegebene Licht bei einem Beobachter keine Blendungen oder störende Reflexionen auf einer reflektierenden Oberfläche, beispielsweise einem Bildschirm oder einer Tischplatte hervorruft.

Da die Einzelanfertigung von Linsen zur Beeinflussung der Lichtabgabe mit einem extrem hohen Aufwand verbunden wäre, kommen üblicherweise Lichtbeeinflussungselemente zum Einsatz, welche aus mehreren miteinander verbundenen Linsen bestehen. Die Anordnung der Linsen ist dabei derart, dass jeder LED genau eine Linse zugeordnet ist, wobei alle Linsen gleichartig ausgestaltet sind und dementsprechend das Licht der jeweiligen LED in identischer Weise beeinflussen. Gemäß einer bekannten Ausführungsform weisen hierbei die kegelstumpfartigen Linsen jeweils eine Kavität, welche einen Lichteintrittsbereich der Linse bildet, sowie eine dem Lichteintrittsbereich gegenüberliegende Lichtaustrittsfläche auf. Derartige, vorzugsweise im Spritzgussverfahren hergestellte Lichtbeeinflussungselemente, werden dann unterhalb der LEDs angeordnet und bilden das bzw. ein Lichtaustrittselement der Leuchte.

Je nach Einsatzgebiet einer Leuchte können unterschiedliche Lichtabstrahlcharakteristiken gewünscht sein. Üblicherweise sind die optischen Elemente einer Leuchte derart ausgelegt, dass das Licht in erster Linie symmetrisch zur Unterseite hin, insbesondere blendfrei abgegeben wird. Bei einem Einsatz in einem Geschäft oder Laden hingegen ist es oftmals erforderlich, seitlich entlang der Leuchte verlaufende Regale gezielt auszuleuchten. In diesem Fall sollte verstärkt Licht auch seitlich abgegeben werden, was in anderen Fällen eher vermieden wird, um ungewünschte Blendungen zu vermeiden. Ferner sind manchmal auch asymmetrische Lichtabstrahlcharakteristiken gewünscht, um beispielsweise benachbarte Wände oder Objekte gezielt aufzuhellen.

Prinzipiell wäre es denkbar, für jeden Anwendungszweck ein entsprechend individuell gestaltetes Lichtbeeinflussungselement mit speziell angepassten Linsen herzustellen. Eine derartige Vorgehensweise ist allerdings mit einem extrem hohen Aufwand verbunden, da die Kosten für ein einzelnes, speziell für die gewünschte Lichtabgabe ausgelegtes Spritzgusswerkzeug sehr hoch sind. Eine weitere Problematik besteht auch darin, dass bei Beleuchtungssystemen, bei denen mehrere Leuchten in Längsrichtung hintereinander angeordnet sind, die Leuchten teilweise eine unterschiedliche Abstrahlcharakteristik aufweisen sollen, andererseits aber ein einheitliches Erscheinungsbild gewünscht ist. Das heißt, die Leuchten sollen zwar Licht in unterschiedlicher Weise abgeben, für einen Betrachter allerdings sollen sie zumindest sehr ähnlich, im Idealfall identisch aussehen.

Aus der CN 101324317 A ist eine Linse für eine LED bekannt, bei der das von der LED abgestrahlte Licht über eine konkave und strukturiert geformte Lichteintrittsfläche in die Linse einstritt. Über eine gegenüberliegende Lichtaustrittsfläche verlässt das Licht die Linse wieder.

Aus der US 2010/0195330 A1 ist eine Linse für eine LED bekannt, bei der das von der LED abgestrahlte Licht über eine mit prismatischen Strukturen versehene Lichteintrittsfläche in die Linse einstrahlt. Über eine Lichtabgabefläche, an der ein, mit Prismen versehener Fortsatz ausgebildet ist, wird das Licht asymmetrisch abgegeben.

Der vorliegenden Erfindung liegt deshalb die Aufgabenstellung zu Grunde, eine neuartige Lösung zum Realisieren von Lichtbeeinflussungselementen der oben genannten Art zur Verfügung zu stellen, mit denen eine Lichtabgabe in der gewünschten Weise erfolgen kann.

Die Aufgabe wird durch ein Lichtbeeinflussungselement mit den Merkmalen des Anspruchs 1 gelöst, vorteilhafte Weiterbildungen der Erfindung sind Gegenstand der abhängigen Ansprüche.

Der Kerngedanke der erfindungsgemäßen Lösung beruht auf der Erkenntnis, dass es bei dem oben genannten Linsentyp mit einer den Lichteintrittsbereich bildenden Kavität zum Erzielen einer gewünschten Lichtabstrahlcharakteristik ausreichend ist, den Lichteintrittsbereich der Linse in entsprechender Weise anzupassen. Insbesondere ist hierbei erfindungsgemäß vorgesehen, im Lichteintrittsbereich der Linse einen sog. Strahlteiler auszubilden, der durch ein oder mehrere Einkerbungen in der Bodenfläche der Kavität gebildet wird. Da eine derartige Modifizierung des Lichteintrittsbereichs der Linsen verhältnismäßig einfach durchgeführt werden kann, besteht dementsprechend ein wesentlicher Vorteil der erfindungsgemäßen Lösung darin, dass Lichtbeeinflussungselemente mit einer gewünschten Lichtabstrahlcharakteristik in einfacher und kostengünstiger Weise hergestellt werden können.
Erfindungsgemäß wird dementsprechend ein Lichtbeeinflussungselement zur Beeinflussung der Lichtabgabe von im Wesentlichen punktförmigen Lichtquellen vorgeschlagen, wobei das Lichtbeeinflussungselement zumindest eine Linse aufweist, welche eine Kavität, die einen Lichteintrittsbereich der Linse bildet, sowie eine dem Lichteintrittsbereich gegenüberliegende Lichtaustrittsfläche aufweist, und wobei erfindungsgemäß im Lichteintrittsbereich der Linse ein Strahlteiler ausgebildet ist. Die erfindungsgemäße Anpassung der Lichtabstrahlcharakteristik durch die Realisierung eines Strahlteilers im Lichteintrittsbereich der Linse ist auch deshalb von Vorteil, da nunmehr der üblicherweise im Lichtaustrittsbereich einer Leuchte angeordnete Strahlteiler bzw. allgemein das Licht beeinflussende Strukturierungen in den Lichteintrittsbereich der Linse verschoben werden und damit für einen Betrachter nicht sichtbar sind. Dies bedeutet, dass das äußere, für den Betrachter sichtbare Erscheinungsbild der Linsenanordnung immer gleich ist und die Abstrahlcharakteristik nun durch die Veränderung der Linse im Inneren bewirkt wird, was bei bisher bekannten Lösungen nicht möglich war.
Der Strahlteiler wird wie bereits angedeutet durch eine oder mehrere Einkerbungen realisiert, die im Bodenbereich der Kavität ausgebildet ist bzw. sind. Je nach Ausgestaltung der Einkerbung(en) kann hierbei die Lichtabgabe eingestellt werden. Dabei bewirkt der Strahlteiler eine asymmetrische Lichtumlenkung.

Die Linsen des erfindungsgemäßen Lichtbeeinflussungselements sind im Wesentlichen kegelstumpfartig ausgebildet, wobei - wiederum zum Erzielen eines möglichst einheitlichen Erscheinungsbilds - die Mantelflächen der Linsen identisch ausgebildet sein können. Die Kavitäten der Linsen können einen polygonalen Querschnitt aufweisen oder rotationssymmetrisch ausgebildet sein.

Ein weiterer Vorteil der erfindungsgemäßen Lösung besteht auch darin, dass insbesondere die Möglichkeit besteht, die Lichtabgabe in eine bestimmte Richtung zu lenken. Sind beispielsweise die Lichteintrittsbereiche der Linsen derart gestaltet, dass eine asymmetrische Lichtabgabe erzielt wird, so kann durch eine entsprechende Anpassung der Orientierung der Linsen die Richtung der Lichtabgabe gezielt beeinflusst werden. Dies ermöglicht es, Licht gezielt zu einer bestimmten Seite hin zu richten und beispielsweise einen sog. Wallwasher zu bilden. Durch eine alternierende Anordnung entsprechend gestalteter Linsen hingegen könnte wiederum eine gleichmäßige Lichtabgabe in unterschiedliche Richtungen realisiert werden. Bei all diesen Varianten können die entsprechenden Lichtbeeinflussungselemente in verhältnismäßig einfacher und kostengünstiger Weise hergestellt werden.

Vorzugsweise weist das Lichtbeeinflussungselement mehrere nebeneinander angeordnete und einstückig miteinanderverbundene Linsen auf. Diese können dabei alle identisch oder auch hinsichtlich ihrer Lichteintrittsbereiche unterschiedlich ausgebildet sind. Ein einheitliches Erscheinungsbild ist allerdings vorzugsweise grundsätzlich dadurch gewährleistet, dass alle Linsen eine identisch ausgestaltete, vorzugsweise rechteckige, insbesondere quadratische Lichtaustrittsfläche aufweisen.

Nachfolgend soll die Erfindung anhand der beiliegenden Zeichnung näher erläutert werden. Es zeigen:
- Figuren 1 und 2: Ansichten einer Leuchte, bei der erfindungsgemäß ausgestaltete Lichtbeeinflussungselemente zum Einsatz kommen;
- Figur 3: die Ansicht eines ersten Ausführungsbeispiels eines erfindungsgemäßen Lichtbeeinflussungselements;
- Figuren 4 und 5: Ansichten von Linsen, wie sie bislang bei einem Lichtbeeinflussungselement entsprechend der Darstellung von Figur 3 zum Einsatz kamen;
- Figuren 6 und 7: eine erste Ausführungsform einer erfindungsgemäßen Linse;
- Figuren 8a und 8b: Lichtverteilungskurven der Linsen der Figuren 4 bis 7;
- Figuren 9 bis 11: Ansichten einer zweiten Ausführungsform einer erfindungsgemäßen Linse;
- Figur 12: die schematische Vorgehensweise zum Erzielen einer symmetrischen Lichtverteilung bei Verwendung asymmetrisch ausgestalteter Linsen;
- Figur 13: eine mögliche Variante zur gleichzeitigen Verwendung von Linsen mit asymmetrischer Lichtabgabe.

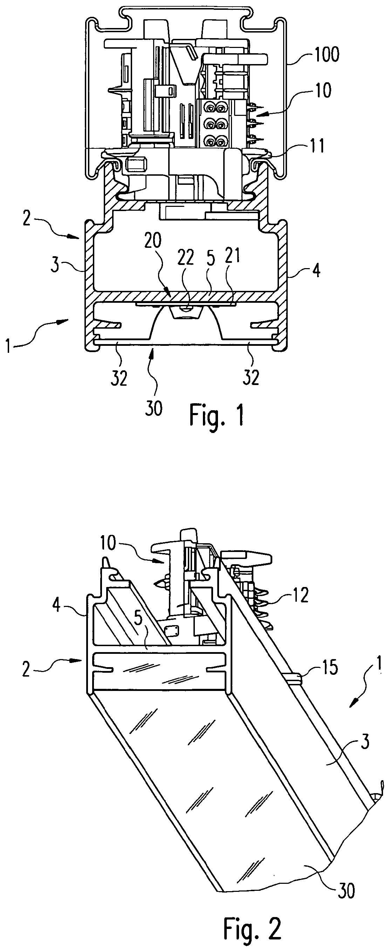

Bevor die Ausgestaltung der erfindungsgemäßen Lichtbeeinflussungselemente bzw. Linsen näher erläutert wird, soll zunächst ein Ausführungsbeispiel einer Leuchte beschrieben werden, bei der bevorzugt derartige Lichtbeeinflussungselemente zum Einsatz kommen. Diese in den Figuren 1 und 2 dargestellte und allgemein mit dem Bezugszeichen 1 versehene Leuchte ist eine sog. Balkenleuchte, also eine länglich ausgebildete Leuchte, die zur Verwendung in einem Stromschienensystem vorgesehen ist. Die erfindungsgemäßen Lichtbeeinflussungselemente sind allerdings keinesfalls auf den Einsatz bei derartigen Balkenleuchten beschränkt sondern können selbstverständlich auch bei anderen Leuchten zum Einsatz kommen, die nicht zum Anschluss an ein Stromschienensystem vorgesehen sind. Hierunter fallen insbesondere auch Wand- oder Stehleuchten.

Die Leuchte 1 weist zunächst als tragendes Element einen länglichen Profilkörper 2 auf, der beispielsweise als Aluminium-Strangpressprofil ausgebildet sein kann. Der Profilkörper 2 besteht aus zwei parallel zueinander verlaufenden Seitenwänden 3 und 4, welche über einen Mittelschenkel 5 miteinander verbunden sind. Im oberen Bereich des Profilkörpers 2 ist ein sog. Drehabgriff 10 verankert, der dazu dient, die mechanische Befestigung der Leuchte 1 an einer Tragschiene 100 zu ermöglichen und ferner innerhalb der Tragschiene 100 verlaufende Leitungen zu kontaktieren. Hierzu weist der Drehabgriff 10 entsprechende Vorsprünge 11 und Kontakte 12 auf, welche durch Verdrehen seitlich ausgeschwenkt werden und hierdurch Vorsprünge an der Tragschiene 100 hintergreifen bzw. in Anlage gegen entsprechende Leiter gelangen. Derartige Drehabgriffe sind bereits bekannt, wozu beispielsweise auf die DE 10 025 647 A1 der Anmelderin verwiesen wird, welche ein entsprechendes sog. Stromschienensystem beschreibt.

Als Lichtquellen kommen im vorliegenden Fall wie bereits erwähnt LEDs zum Einsatz. Hierzu sind an der Unterseite des Mittelschenkels 5 des Profilkörpers 2 in Längsrichtung hintereinander mehrere LED-Module 20 angeordnet, die jeweils eine längliche Platine 21 sowie darauf angeordnete LEDs 22 aufweisen. Bei einer Leuchte üblicher Länge sind in der Regel etwa vier bis fünf derartige LED-Module 20 in Längsrichtung hintereinander angeordnet. Die Befestigung dieser LED-Module 20 an dem Mittelschenkel 5 erfolgt vorzugsweise mittels Verkleben, wobei allerdings auch eine Schraub- oder Rastverbindung denkbar wäre. Insbesondere sollte ein guter thermischer Kontakt zwischen LED-Modul 20 und Mittelschenkel 5 vorliegen, um eine effektive Abführung der während des Betriebs der LEDs 22 auftretenden Wärme zu ermöglichen. Darauf hinzuweisen ist, dass unter dem Begriff LEDs im vorliegenden Fall sowohl einzelne LEDs also auch LED-Cluster, beispielsweise eine RGB-Anordnung zu verstehen sind.

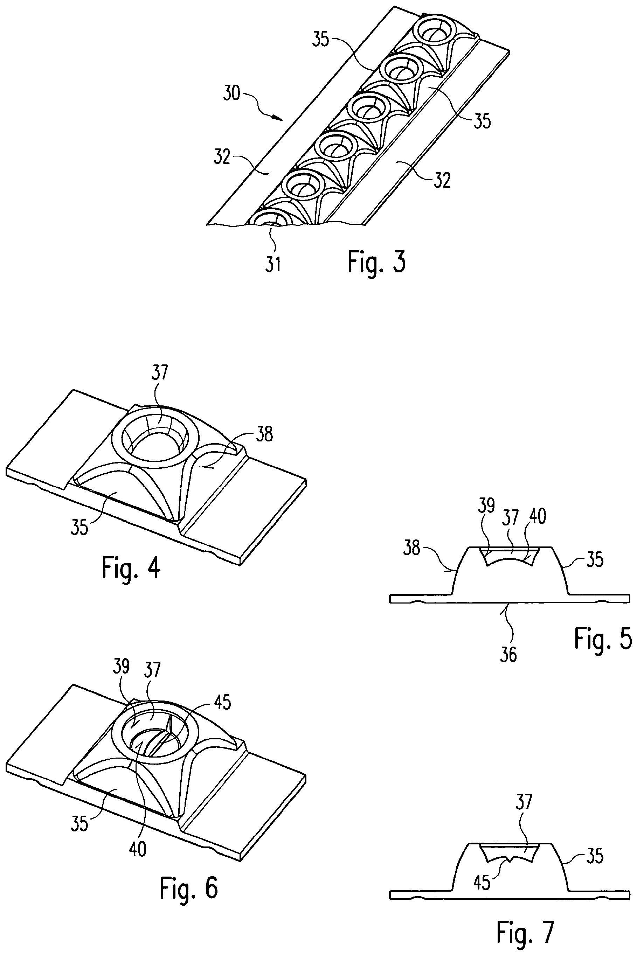

Die Abstrahlung des von den LEDs 22 emittierten Lichts erfolgt mit Hilfe eines Lichtbeeinflussungselements 30, dessen Ausgestaltung insbesondere Figur 3 entnommen werden kann.

Das aus einem transparenten Kunststoffmaterial bestehende Lichtbeeinflussungselement 30 ist länglich ausgebildet und weist einen zentralen mittleren Bereich 31 auf, der durch mehrere in Längsrichtung hintereinander angeordnete Linsen 35 gebildet wird. Die Abmessungen und Anordnung der Linsen 35 sind dabei derart, dass jeder LED 22 eine eigene Linse 35 zugeordnet ist. Das einstückig ausgebildete Lichtbeeinflussungselement 30 weist vorzugsweise eine Länge auf, die derjenigen einer LED-Platine 20 entspricht. Mit Hilfe zweier seitlich abstehender Arme 32, die vorzugsweise ebenfalls transparent sind, kann das Element an dem Profilkörper 2 befestigt, beispielsweise mit diesem verklemmt werden.

Bei einem derartigen Lichtbeeinflussungselement 30 kamen bislang oftmals Linsen 35 zum Einsatz, wie sie in den Figuren 4 und 5 dargestellt sind. Jede Linse 35 ist hierbei in etwa kegelstumpfartig ausgebildet und weist an ihrer Unterseite eine rechteckige, vorzugsweise quadratische Grundfläche auf, welche die Lichtaustrittsfläche 36 bildet und über die letztendlich die Lichtabgabe erfolgt. An der der Lichtaustrittsfläche 36 gegenüberliegenden Seite des Linsenkörpers ist eine Ausnehmung bzw. Kavität 37 ausgebildet, deren Umfangsfläche und Bodenfläche den Lichteintrittsbereich der Linse 35 bildet.

Wie der Darstellung von Figur 1 entnommen werden kann, ragt in montiertem Zustand des Lichtbeeinflussungselements 30 an dem Profilkörper 2 die LED 22 leicht in die zugehörige Kavität 37. Da das Licht der LED 22 über einen sehr breiten Winkelbereich im Wesentlichen rotationssymmetrisch abgegeben wird, wird Licht sowohl über die Bodenfläche als auch über die Mantelfläche der Kavität 37 in den Linsenkörper eingekoppelt. Ein Teil des Lichts gelangt hierbei unmittelbar zu der Lichtaustrittsfläche 36 und wird über diese abgegeben. Ein weiterer Teil des Lichts hingegen wird an der Mantelfläche 38 des kegelstumpfartigen Linsenkörpers totalreflektiert und auf diese Weise auf die Lichtaustrittsfläche 36 gelenkt.

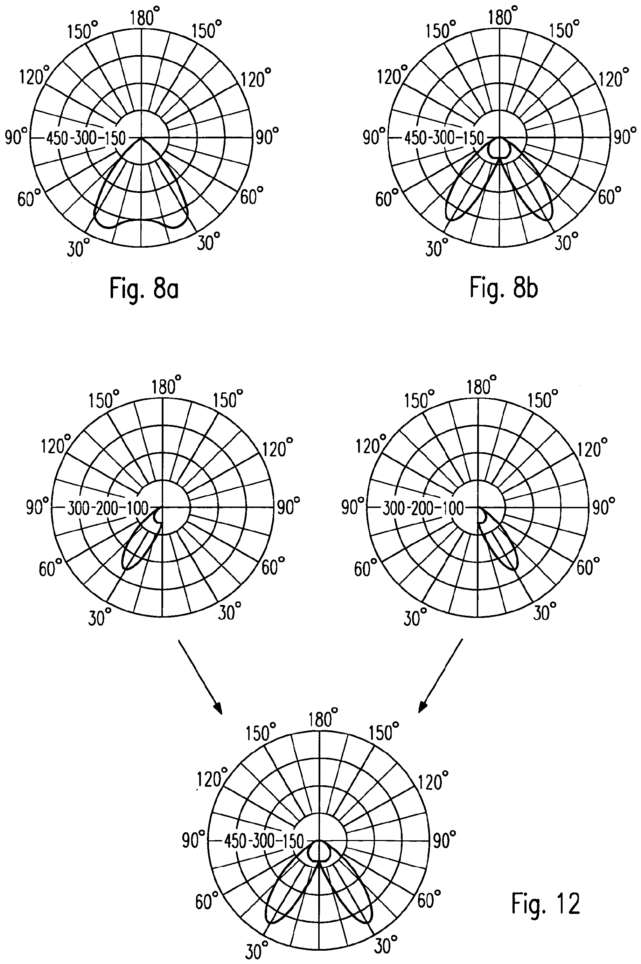

Im dargestellten Beispiel sind die Kavitäten 37 der Linsen 35 rotationssymmetrisch ausgebildet. Sie weisen leicht gekrümmte Seitenflächen 39 sowie eine gewölbte Bodenfläche 40 auf. Bei einer derartigen Ausgestaltung wird eine Lichtverteilung erzielt, wie sie schematisch in Figur 8a dargestellt ist. Es ist erkennbar, dass eine konzentrierte Lichtabgabe unmittelbar zur Unterseite hin erfolgt. Eine derartige Lichtabgabe ist beispielsweise erwünscht, wenn eine Blendung von Personen, die sich im Bereich der Leuchte aufhalten, unter flachen Blickwinkeln vermieden werden soll.

Wird hingegen die Leuchte im Geschäftsbereich, beispielsweise zwischen zwei parallel zueinander verlaufenden Regalreihen- oder wänden eingesetzt, so ist oftmals eher eine Lichtverteilung gewünscht, wie sie schematisch in Figur 8b dargestellt ist. In diesem Fall soll also weniger Licht unmittelbar nach unten abgegeben sondern vermehrt in zwei einander gegenüberliegende seitliche Bereiche symmetrisch abgestrahlt werden.

Zur Realisierung einer derartigen anderen Lichtverteilungskurve war es bislang erforderlich, ein vollständig neues Lichtbeeinflussungselement zu entwickeln bzw. im Lichtausgangsbereich der Leuchte zusätzliche optische Mittel anzuordnen. Die Herstellung eines entsprechenden eigenen Spritzgusswerkzeugs hierfür war allerdings mit einem sehr hohen Kostenaufwand verbunden.

Erfindungsgemäß wird nunmehr eine Lösung vorgeschlagen, welche das Anpassen der Lichtverteilungscharakteristik deutlich vereinfacht. Diese Lösung beruht auf der Erkenntnis, dass insbesondere durch eine entsprechende Gestaltung des Lichteintrittsbereichs der Linsen 35 die Lichtverteilung in gewünschter Weise angepasst werden kann. Die weiteren Elemente der Linse 35 hingegen, insbesondere die Lichtaustrittsfläche 36 sowie die Mantelfläche 38 des Linsenkörpers müssen nicht verändert werden und der Einsatz zusätzlicher optischer Mittel ist nicht erforderlich. Dies führt einerseits zu dem Vorteil, dass auch bei unterschiedlicher Lichtabstrahlcharakteristik das Erscheinungsbild des Lichtbeeinflussungselements unverändert bleibt. Ferner ist die Herstellung eines entsprechend gestalteten Lichtbeeinflussungselements mit veränderter Lichtverteilungskurve nunmehr deutlich kostengünstiger.

Eine erste Variante einer erfindungsgemäßen Linse ist hierbei in den Figuren 6 und 7 gezeigt, wobei sich die dargestellte Linse 35 dadurch auszeichnet, dass die Kavität 37 des Lichteintrittsbereichs einen Strahlteiler 45 aufweist. Im vorliegenden Fall wird dieser Strahlteiler 45 durch eine einzelne Einkerbung gebildet, welche in erster Linie in der Bodenfläche 40 der Kavität 37 ausgebildet ist, sich allerdings ggf. auch durch die Umfangsfläche 39 der Kavität erstrecken kann. Durch diese Einkerbung wird wie bereits erwähnt ein Strahlteiler 45 realisiert, der das auftreffende Licht, welches an sich im Wesentlichen ungehindert zur Unterseite hin abgegeben wird, seitlich auslenkt bzw. aufspaltet, so dass letztendlich die angestrebte symmetrische, seitliche Lichtabstrahlung gemäß Figur 8b erzielt wird.

Die Besonderheit der erfindungsgemäßen Lösung liegt darin, dass der üblicherweise im Lichtaustrittsbereich einer Leuchte angeordnete Strahlteiler bzw. allgemein ein üblicherweise im Lichtaustrittsbereich angeordnetes zusätzliches optische Element nunmehr in den Lichteintrittsbereich der Linse verschoben wird, was zur Folge hat, dass es für einen Betrachter nicht sichtbar ist. Dies bedeutet, dass das äußere, für den Betrachter sichtbare Erscheinungsbild der Linsenanordnung immer gleich ist, insbesondere dem Erscheinungsbild eines Lichtbeeinflussungselement mit den bekannten Linsen entsprechend Figur 4 und 5 entspricht, die Lichtabstrahlcharakteristik allerdings durch die Veränderung der Linse im Inneren stark verändert und insbesondere individuellen Wünschen angepasst werden kann.

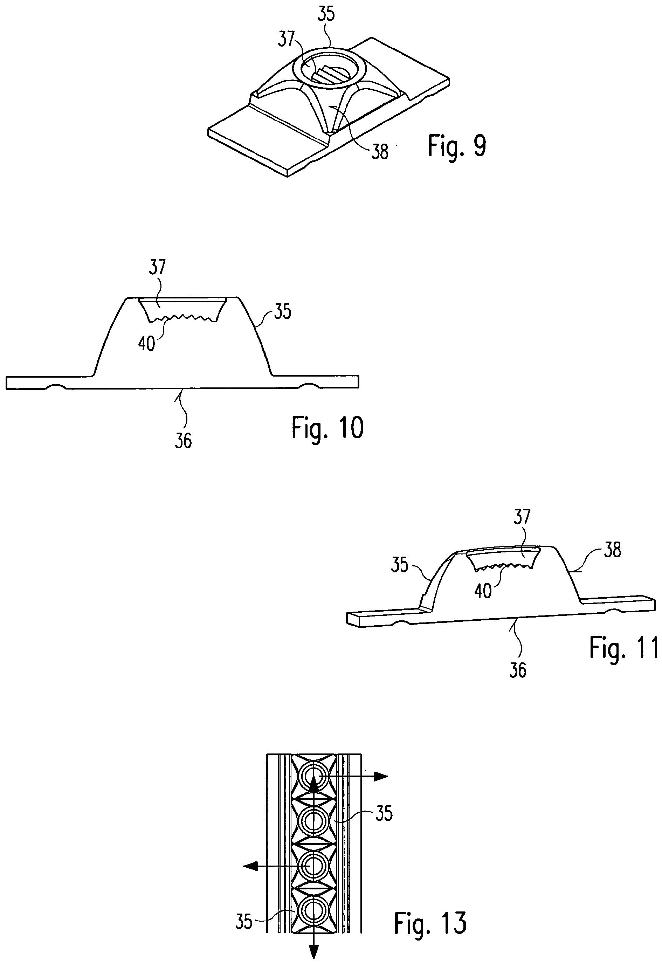

Eine zweite Möglichkeit zur Realisierung des erfindungsgemäßen Strahlteilers ist in den Figuren 9 bis 11 dargestellt. Die in diesen Figuren gezeigte Linse 35 gleicht im Hinblick auf ihren Linsenkörper und den Lichtaustrittsbereich den zuvor gezeigten Linsen 35, sie ist in einem in der Leuchte montierten Zustand also nicht von den anderen Linsen zu unterscheiden. Auch bei dieser Variante ist allerdings der Lichteintrittsbereich, insbesondere die Bodenfläche 40 der Kavität 37 in spezieller Weise gestaltet, um letztendlich eine gewünschte Lichtabstrahlcharakteristik zu erzielen. Im vorliegenden Fall ist nunmehr die Bodenfläche 40 geriffelt ausgebildet, besteht also aus mehreren nebeneinander verlaufenden Einkerbungen, durch welche wiederum ein Strahlteiler 45 gebildet wird. Auch in diesem Fall wird dementsprechend eine Umlenkung bzw. Aufspaltung des Lichts erzielt, so dass eine Lichtverteilungskurve entsprechend Figur 8b erhalten wird.

Eine weitere Möglichkeit zur Nutzung eines Strahlteilers besteht auch darin, den Lichteintrittsbereich einer Linse derart auszugestalten, dass eine asymmetrische Lichtabgabe erzielt wird, wie sie beispielsweise schematisch im oberen linken Bereich von Figur 12 dargestellt ist. Dabei wird unter einem Strahlteiler allgemein eine optische Maßnahme - im vorliegenden Fall eine entsprechende Gestaltung des Lichteintrittsbereichs der Linse - bezeichnet, durch welche das Licht in eine oder mehrere gewünschte Richtungen umgelenkt bzw. aufgespaltet wird. Auch eine derartige Lichtabstrahlcharakteristik gemäß Figur 12 kann durch eine entsprechende Anpassung der Kavität bzw. dem Lichteintrittsbereich der Linse erzielt werden, ohne dass hierfür der Lichtaustrittsbereich oder die Form der Mantelfläche des Linsenkörpers angepasst werden müssten.

Werden ausschließlich derartige asymmetrisch gestaltete Linsen verwendet, so wird das Licht ausschließlich in den linken unteren Bereich seitlich abgestrahlt und kann beispielsweise dazu genutzt werden, einen dort befindlichen Wandbereich oder ein Objekt auszuleuchten. Eine Leuchte mit einen derartigen Lichtbeeinflussungselement könnte also als sog. Wallwasher verwendet werden, wobei sie allerdings für einen Betrachter von einer Leuchte, welche eine Lichtabstrahlcharakteristik gemäß Figur 8a oder 8b aufweist, nicht zu unterscheiden ist, da die Lichtbeeinflussungselemente 30 hinsichtlich ihres Lichtaustrittsbereichs grundsätzlich identisch ausgestaltet sind. In gleicher Weise könnte selbstverständlich auch die Ausgestaltung der Linsen derart erfolgen, dass das Licht zur rechten unteren Seite abgegeben wird, wie im rechten oberen Bereich von Figur 12 gezeigt ist.

Werden nunmehr allerdings innerhalb eines Lichtbeeinflussungselements alternierend Linsen eingesetzt, welche einerseits primär nach links und andererseits primär nach rechts abstrahlen, so wird insgesamt eine "gemittelte" Lichtstrahlcharakteristik erzielt, wie sie im unteren Bereich von Figur 12 gezeigt ist. Es wird also wiederum eine zu beiden Seiten symmetrisch abstrahlende Lichtverteilungskurve, die im Wesentlichen derjenigen von Figur 8b entspricht, erzielt.

Eine weitere Möglichkeit zur Nutzung unterschiedlich orientierter, asymmetrisch gestalteter Linsen ist in Figur 13 dargestellt. Hier sind aufeinanderfolgende Linsen 35 jeweils derart ausgebildet, dass die asymmetrische Lichtabgabe - schematisch mit einem Pfeil angedeutet ist - jeweils um 90° verdreht ist. In Kombination wird hierdurch eine Lichtabgabe in sämtliche vier Hauptrichtungen erzielt.

Ferner wäre es auch denkbar, die zur asymmetrischen Lichtabgabe ausgebildeten Linsen derart zu orientieren, dass die Lichtabgabe entlang der Längsrichtung der Leuchte erfolgt. Hierdurch könnte ein Objekt oder eine Wand in einem Stirnbereich einer Leuchte gezielt beleuchtet werden. Ein geeignetes Anwendungsgebiet hierfür wäre beispielsweise eine sog. Tafelbeleuchtung, wobei hierfür auf zusätzliche, senkrecht zur allgemeinen Beleuchtung ausgerichtete Leuchten verzichtet werden könnte.

All diese Ausführungsbeispiele verdeutlichen, dass das Einbringen eines Strahlteilers im Lichteintrittsbereich einer Linse deutliche Vorteile mit sich bringt, da auf diesem Wege oder den Einsatz zusätzlicher optischer Mittel unterschiedlichste Lichtabstrahlcharakteristiken für ein Lichtbeeinflussungselement erzielt werden können, wobei allerdings das Erscheinungsbild des Lichtbeeinflussungselements für eine Betrachter unverändert bleibt.

## Patentansprüche

1. Lichtbeeinflussungselement (30) zur Beeinflussung der Lichtabgabe von im Wesentlichen punktförmigen Lichtquellen (22),
wobei das Lichtbeeinflussungselement (30) zumindest eine Linse (35) aufweist, welche
a) eine Kavität (37), welche einen Lichteintrittsbereich der Linse (35) bildet, sowie
b) eine dem Lichteintrittsbereich gegenüberliegende Lichtaustrittsfläche (36) aufweist,
wobei im Lichteintrittsbereich der Linse (35) ein Strahlteiler (45) ausgebildet ist, wobei der Strahlteiler (45) durch eine oder mehrere Einkerbungen in der Bodenfläche (40) der Kavität (37) gebildet ist,
**dadurch gekennzeichnet,**
**dass** der Strahlteiler (45) eine asymmetrische Lichtabgabe bewirkt, wobei die Lichtaustrittsfläche (36) rechteckig ausgestaltet ist.

2. Lichtbeeinflussungselement nach Anspruch 1,
**dadurch gekennzeichnet,**
**dass** die Kavität (37) einen polygonalen Querschnitt aufweist.

3. Lichtbeeinflussungselement nach Anspruch 1,
**dadurch gekennzeichnet,**
**dass** die Kavität (37) rotationssymmetrisch ausgebildet ist.

4. Lichtbeeinflussungselement nach einem der vorherigen Ansprüche,
**dadurch gekennzeichnet,**
**dass** dieses mehrere nebeneinander angeordnete und einstückig miteinander verbundene Linsen (35) aufweist.

5. Lichtbeeinflussungselement nach Anspruch 4,
**dadurch gekennzeichnet,**
**dass** alle Linsen (35) identisch ausgestaltete, vorzugsweise rechteckige, insbesondere quadratische Lichtaustrittsflächen (36) aufweisen.

6. Lichtbeeinflussungselement nach Anspruch 4 oder 5,
**dadurch gekennzeichnet,**
**dass** die Linsen (35) im Wesentlichen kegelstumpfartig ausgebildet sind, wobei die Mantelflächen (38) der Linsen (35) identisch ausgebildet sind.

7. Lichtbeeinflussungselement nach einem der Ansprüche 4 bis 6,
**dadurch gekennzeichnet,**
**dass** die Kavitäten (37) von zumindest zwei der Linsen (35) unterschiedlich ausgebildet sind und sich insbesondere in der Ausgestaltung der Bodenfläche (40) unterscheiden.

8. Lichtbeeinflussungselement nach Anspruch 7,
**dadurch gekennzeichnet,**
**dass** mehrere Linsen (35) jeweils einen Stahlteiler (45) aufweisen, der eine asymmetrische Lichtabgabe bewirkt und insbesondere durch Einkerbung gebildet ist, wobei die Strahlteiler der Linsen (35) unterschiedlich zueinander orientiert sind.

9. Leuchte (1) mit mehreren nebeneinander angeordneten, im Wesentlichen punktförmigen Lichtquellen (22) sowie einem den Lichtquellen (22) zugeordneten Lichtbeeinflussungselement nach einem der vorherigen Ansprüche.

10. Leuchte nach Anspruch 9,
**dadurch gekennzeichnet,**
**dass** die Lichtquellen durch LEDs oder LED-Cluster gebildet sind.

## Claims

1. A light-influencing element (30) for influencing the light output of essentially punctiform light sources (22),
with the light-influencing element (30) having at least one lens (35), which has
a) a cavity (37), which forms a light inlet region of the lens (35), and
b) a light outlet surface (36) opposite the light inlet region,
with a beam splitter (45) being formed in the light inlet region of the lens (35),
with the beam splitter (45) being formed by one or several indentations in the floor area (40) of the cavity (37),
**characterized in that**
the beam splitter (45) creates an asymmetric light output, with the light outlet surface (36) being rectangular in design.

2. The light-influencing element according to Claim 1,
**characterized in that**
the cavity (37) has a polygonal cross section.

3. The light-influencing element according to Claim 1,
**characterized in that**
the cavity (37) is configured as rotationally symmetric.

4. The light-influencing element according to any one of the preceding claims,
**characterized in that**
said element has several lenses (35) that are arranged beside one another and connected to one another in one piece.

5. The light-influencing element according to Claim 4,
**characterized in that**
all lenses (35) have identically designed, preferably rectangular, in particular square, light outlet surfaces (36).

6. The light-influencing element according to Claim 4 or 5,
**characterized in that**
the lenses (35) are essentially configured as truncated cones, wherein the shell surfaces (38) of the lenses (35) are identically configured.

7. The light-influencing element according to any one of Claims 4 to 6,
**characterized in that**
the cavities (37) of at least two of the lenses (35) are configured differently and in particular differ in the design of the floor area (40).

8. The light-influencing element according to Claim 7,
**characterized in that**
several lenses (35) in each case have a beam splitter (45), which creates an asymmetric light output and which in particular is formed by indentation, with the beam splitters of the lenses (35) being oriented differently with respect to each other.

9. A light (1) having several essentially punctiform light sources (22) arranged beside one another and a light-influencing element according to one of the preceding claims assigned to the light sources (22).

10. The light according to Claim 9,
**characterized in that**
the light sources are formed by LEDs or LED clusters.

## Revendications

1. Élément influençant la lumière (30) pour l'influence de l'émission de lumière de sources de lumière (22) essentiellement ponctuelles,
l'élément influençant la lumière (30) comprenant au moins une lentille (35), laquelle comprend
a) une cavité (37), laquelle est formée dans une zone d'entrée de lumière de la lentille (35), ainsi
b) qu'une surface de sortie de lumière (36) opposée à la zone d'entrée de lumière
un séparateur de faisceau (45) étant formé dans la zone d'entrée de lumière de la lentille (35),
le séparateur de faisceau (45) étant formé par une ou plusieurs encoches dans la surface de fond (40) de la cavité (37),
**caractérisé en ce**
**que** le séparateur de faisceau (45) entraîne une émission de lumière asymétrique, la surface de sortie de lumière (36) étant de forme rectangulaire.

2. Élément influençant la lumière selon la revendication 1,
**caractérisé en ce**
**que** la cavité (37) présente une section transversale polygonale.

3. Élément influençant la lumière selon la revendication 1,
**caractérisé en ce**
**que** la cavité (37) est formée de manière asymétrique en rotation.

4. Élément influençant la lumière selon l'une quelconque des revendications précédentes,
**caractérisé en ce**
**que** celui-ci comprend plusieurs lentilles (35) disposées les unes à côté des autres et reliées solidairement.

5. Élément influençant la lumière selon la revendication 4,
**caractérisé en ce**
**que** toutes les lentilles (35) comprennent des surfaces de sortie de lumière (36) de formes identiques, de préférence rectangulaires, en particulier carrées.

6. Élément influençant la lumière selon la revendication 4 ou 5,
**caractérisé en ce**
**que** les lentilles (35) ont une forme essentiellement tronconique, les surfaces d'enveloppe (38) des lentilles (35) étant de formes identiques.

7. Élément influençant la lumière selon l'une quelconque des revendications 4 à 6,
**caractérisé en ce**
**que** les cavités (37) d'au moins deux des lentilles (35) sont de formes différentes et se différencient en particulier par la conception de la surface de fond (40).

8. Élément influençant la lumière selon la revendication 7,
**caractérisé en ce**
**que** plusieurs lentilles (35) comprennent chacune un séparateur de faisceau (45), qui entraîne une émission de lumière asymétrique et qui est formé en particulier par des encoches, les séparateurs de faisceaux des lentilles (35) sont orientés différemment les uns par rapport aux autres.

9. Luminaire (1) comprenant plusieurs sources de lumière (22) essentiellement ponctuelles disposées les unes à côté des autres ainsi qu'un élément influençant la lumière selon l'une quelconque des revendications précédentes, associé aux sources de lumière (22).

10. Luminaire selon la revendication 9,
**caractérisé en ce**
**que** les sources de lumières sont formées de LED ou de groupes de LED.
